# EUROPÄISCHE PATENTSCHRIFT

(11) **EP 0 533 715 B1**
(45) Veröffentlichungstag und Bekanntmachung des Hinweises auf die Patenterteilung: **07.12.1994**
(21) Anmeldenummer: 91910411.7
(22) Anmeldetag: 13.06.1991
(51) Int. Cl.: H03H 9/02, H03H 9/145

(54) **INTERDIGITALWANDLER MIT FINGERBREITEN-WICHTUNG FÜR OBERFLÄCHENWELLENANORDNUNGEN**
INTERDIGITAL TRANSDUCER WITH FINGER WIDTH WEIGHTING FOR SURFACE WAVE ARRANGEMENTS
CONVERTISSEUR INTERDIGITAL AVEC PONDERATION PAR LARGEUR DE DOIGT POUR AGENCEMENTS D'ONDES DE SURFACE

(30) Priorität: 13.06.1990 DE 4019004
(43) Veröffentlichungstag der Anmeldung: 31.03.1993
(73) Patentinhaber: SIEMENS AKTIENGESELLSCHAFT, 80333 München (DE)
(72) Erfinder: MACHUI, Jürgen, D-8000 München 40 (DE)
(86) Internationale Anmeldenummer: DE9100496
(87) Internationale Veröffentlichungsnummer: WO9120127

(56) Entgegenhaltungen:
- EP-A- 369 835
- DE-A- 2 546 193
- PHILIPS TECHNISCH TIJDSCHRIFT Bd. 32 Nr. 10 1971, EINDHOVEN NL Seiten 331-342
- MITCHEL: 'Filters, werkend met akoustische oppervlaktegolven' Seite 335, linke Spalte, Zeile 40 - Zeile 51 Abbildungen 7,8

## Beschreibung

Die vorliegende Erfindung bezieht sich auf einen Interdigitalwandler für Oberflächenwellenanordnungen mit den Merkmalen des Obergriffes des Patentanspruchs 1.

Seit etwa zwei Jahrzehnten sind mit akustischen Wellen, die sich in der Oberfläche eines Substrats ausbreiten, arbeitende Oberflächenwellenanordnungen bekannt. Solche Anordnungen werden anstelle von aus Induktivitäten und Kapazitäten bestehenden Anordnungen als elektronische Filter verwendet. Die als Ausgangs- bzw. Eingangswandler zu verwendenden Interdigitalwandler bestehen aus einer Anzahl fingerförmiger Elektrodenstreifen, die auf der Substratoberfläche in interdigitaler Zuordnung zueinander angeordnet sind, nämlich wobei alternierend diese Finger mit der einen bzw. mit der anderen Sammelschiene (elektrisch) verbunden sind.

Um ein Filter mit einer vorgegebenen Filterkurve zu haben, ist es ebensolange bekannt, die Überlappungslängen der interdigitalen Finger des Wandlers der Filterkurve angepaßt zu wählen. Es ist dies so die sogenannte Überlappungswichtung.

Beispiele einer Überlappungswichtung sind in der EP-A-0 188 263 und der DE-A-25 46 193 beschrieben. Beide Beispiele haben außerdem ein solches Design, daß die Wandler reflexionsfrei sind. Die Fingerbreiten und die Fingerzwischenräume sind grundsätzlich Lambda-periodisch positioniert. Einzelne Verschiebungen sind für die Reflexionsfreiheit erforderlich.

In der nicht vorveröffentlichten DE-A-40 10 310 ist eine Oberflächenwellenstruktur beschrieben, die auch überlappungsgewichtet sein kann. Bei dieser Struktur sind endständige Finger vorgesehen, die hinsichtlich ihrer Fingerbreite und ihres Fingerabstandes unterschiedliche Bemessungen gegenüber den sonstigen Fingern der Struktur haben. Diese abweichend bemessenen Finger sind nicht gewichtet und dienen lediglich dazu, Reflexionen zu unterdrücken, die ansonsten von endständigen Fingern ausgehen.

Weiter bekannt ist die Fingerweglaß-Wichtung, wobei die gewünschte Wichtung des Wandlers durch gezieltes Weglassen einzelner Finger des Wandlers realisiert wird. Weggelassene Finger können dabei durch nicht-alternierend elektrisch angeschlossene Finger ersetzt sein. Desweiteren ist Finger-Verschiebungswichtung bekannt, bei der einzelne vorgegebene Finger des Wandlers gegenüber der vorgegebenen Periodizität des Wandlers verschoben angeordnet sind. Diese Finger sind damit nicht mehr exakt in Phase mit der Wandlerperiodizität des vergleichsweise nicht gewichteten Interdigitalwandlers.

Ein Beispiel einer Fingerweglaß-Wichtung ist in der EP-A-0 369 835 beschrieben. Die Figur 7 dieser Druckschrift zeigt eine interdigitale Fingerstruktur mit Fingern, deren Mittenabstände nicht-periodisch sind. An den Enden des Wandlers beträgt der Finger-Mittenabstand 4,5 Lambda, in der Mitte des Wandlers beträgt er 1 Lambda und Abstände anderer Finger haben Werte zwischen diesen Vielfachen der Wellenlänge Lambda. Für die Fingerzwischenräume ist keine eigene Ordnungsvorschrift gegeben.

Diese voranstehend genannten Wichtungsarten sind mit ihren Vorteilen und Nachteilen im Stand der Technik schon hinlänglich beschrieben worden. Die Überlappungswichtung führt zu Problemen mit der Einhaltung der Apertur eines Wandlers. Der überlappungsgewichtete Wandler kann in vielen seiner Eigenschaften nur zweidimensional beschrieben werden. Insbesondere bei nur kleinen Überlappungslängen macht sich ein Einfluß von Technologietoleranzen stark bemerkbar. Daraus resultieren oft Probleme beim Design von Filtern und in der Reproduzierbarkeit an kritischen Punkten. Außerdem setzt man nur ungern zwei überlappungsgewichtete Wandler in einem Filter einander direkt gegenüberstehend ein. Dabei kommt nämlich die Schwierigkeit hinzu, jede einzelne Anregung im als Eingangswandler arbeitenden Wandler mit jeder detektierenden Überlappung des als Ausgangswandler arbeitenden Wandlers korrelieren zu müssen. Bekannt ist, zum Beispiel bei Fernseh-Bandpaßfiltern nur den einen Wandler zu wichten und dem zweiten Wandler ein Zeitsignal, das einem einfachen Rechteck entspricht, zu geben.

Die ohnehin seltener angewendete Methode der Fingerweglaßwichtung hat den Nachteil, daß das gewünschte Zeitsignal nicht gut abgetastet werden kann, denn es stehen für jede Überlappung nur "Einsen" und "Nullen", nämlich vorhandene Finger und weggelassene Finger, zur Verfügung, so daß die Dynamik dieser Wichtungsmethode meistenteils unzulänglich ist.

Mit der noch nachfolgend zu beschreibenden Erfindung sollen die Mängel des Standes der Technik behoben werden. Es ist somit Aufgabe der vorliegenden Erfindung, eine Wichtungsmethode für interdigitale Wandler für Oberflächenwellenanordnungen anzugeben, mit der die zu realisierende, vorgegebene Filterfunktion besser auf Eingangswandler und Ausgangswandler des Filters aufgeteilt werden kann und/oder/mit der wesentlich niedrigere Sidelobes (Nebenmaxima), zu erzielen und/oder/mit der bei gleicher Substratlänge bessere Filtercharakteristiken zu erhalten sind, ohne daß höhere Anforderungen hinsichtlich der Technolgietoleranzen gestellt werden müssen.

Diese Aufgabe bzw. deren im Einzelfall jeweils auftretende Schwerpunktprobleme werden mit einem Interdigitalwandler mit den Merkmalen des Patentanspruches 1 gemäß der vorliegenden Erfindung gelöst.

Es sei noch auf nur scheinbar relevanten Stand der Technik hingewiesen, nämlich auf die Druckschriften US-A-3 936 774 und 4 162 465. Beide Druckschriften zeigen nicht-gewichtete Strukturen. Die erstgenannte Druckschrift betrifft eine dispersive Struktur mit entsprechend der Bandbreite unterschiedlichen Fingerabständen. Die zweite Druckschrift betrifft einen Wandler, bei dem die unterschiedliche Fingerpositionierung und unterschiedliche Fingerbreite über den Wandler hinweg periodisch ist, also diesbezüglich keine Wichtung vorliegt. Dieses Design des Wandlers dient dazu, in dem Wandler einen bestimmten reflektierten Wellenanteil zu erzeugen, der mit einem Signalanteil interferiert, der auf der elektrischen Signalreflexion am Lastwiderstand beruht.

Für die vorliegende Erfindung ist eine neue Wichtungsmethode gefunden worden, die in einer Breiten-Variation der vorgesehenen interdigitalen Finger des Wandlers besteht. Nur scheinbar ist diese neue Fingerwichtung an die bekannte Fingerverschiebungswichtung angelehnt. In der Tat hat diese neue Methode der Fingerwichtung andere physikalische Grundlagen. Bei der vorliegenden Erfindung haben die streifenförmigen Zwischenräume zwischen zwei benachbarten Wandlerfingern prinzipiell einheitlich gleich große Breite (in Richtung der Haupt-Wellenfortpflanzungsrichtung). Die einzelnen Finger des Wandlers sind dagegen entsprechend dem Maß der örtlichen Wichtung im Wandler verschieden breit. Die sich im Material des Substrats ergebende Wellenlänge der für die Mittenfrequenz des Filters im Wandler auftretenden akustischen Welle bestimmt in Richtung der Haupt-Wellenausbreitungsrichtung (orthogonal zur Ausrichtung der Finger) die Periodizität p (= Lambda) der Welle. Die Wandlerfinger eines erfindungsgemäß gewichteten Interdigitalwandlers sind (wenigstens in einem Bereich des Wandlers) so positioniert, daß die Mittelpunkte der Wandlerfinger, gesehen in Richtung der Breite der Finger, das heißt gesehen in Richtung der Haupt-Wellenausbreitungsrichtung, mit dieser Periodizität 2p übereinstimmt. Das heißt, daß von der Mitte des einen Fingers bis zur Mitte des jeweils benachbarten Fingers stets das Periodizitätsmaß p/2 eingehalten ist. Dies ist bei der bekannten Finger-Verschiebungswichtung nämlich nicht der Fall.

Bei einem erfindungsgemäßen Wandler ist geringe Aktivität dort vorhanden, wo sich besonders breite Finger der einen Sammelschiene, das heißt der einen Polarität, und besonders schmale Finger der anderen Sammelschiene abwechseln. Bei einem Fingerlängen-gewichteten Wandler wäre dies der Bereich geringer Überlappungslängen mit großem Beugungseffekt. Bei der Erfindung ist dieser nachteilige Beugungseffekt ausgeschlossen.

Vergleichsweise zu Wandlern mit bekannter Fingerwichtung ist es häufig der Fall, daß erfindungsgemäß gewichtete Wandler eine Breite des Zwischenraums zwischen benachbarten Fingern haben, die kleiner ist als es bekannten Wandlern mit Abmessungen entspricht, bei denen die Fingerbreite gleich der Breite des Fingerzwischenraums ist, nämlich jeweils Lambda/4.

Zum Beispiel ist bei der Erfindung vorgesehen, die gleichbleibend groß bemessene Breite der Fingerzwischenräume bis zu einem der Breite der breitesten im gewichteten Wandler vorkommenden Fingerbreite zu wählen. Bei einer technologischen derzeit gegebenen Grenze der optischen Auflösung für die Herstellung der Fingerstrukturen von 0,5 µm heißt dies, daß ohne Schwierigkeiten nach der Erfindung gewichtete Wandler Mittenfrequenzen bis in den Bereich von 500 MHz haben können. Insbesondere wird damit der gesamte Bereich der Fernsehzwischenfrequenzfilter ohne Schwierigkeiten abgedeckt.

Ein erfindungsgemäßer Wandler hat im Regelfall durchgängig gleiche Fingerlänge. Trotz kleiner Wandlerwichtung am Anfang und am Ende eines solchen Wandlers ist dessen Apertur nicht verändert.

Bei der Erfindung sind aber die Mitten der Fingerzwischenräume nicht entsprechend der Periodizität p positioniert.

Bei der Erfindung kann der erfindungsgemäßen Fingerbreiten-Wichtung auch noch ein gewisses Maß Finger-Überlappungswichtung überlagert sein, womit ein größerer Wichtungsspielraum zu gewinnen ist. Das dann vorgesehen Überlappungsmaß wird jedoch sehr begrenzt gehalten, das heißt es wird stets eine Mindest-Überlappungslänge eingehalten, um unerwünschte Beugungseffekte an den Enden des Wandlers weiterhin auszuschließen oder vorgebbar zu begrenzen.

Weitere Erläuterungen der Erfindung gehen aus der nachfolgenden Beschreibung zu den Figuren hervor, in denen Ausführungsformen angegeben sind.

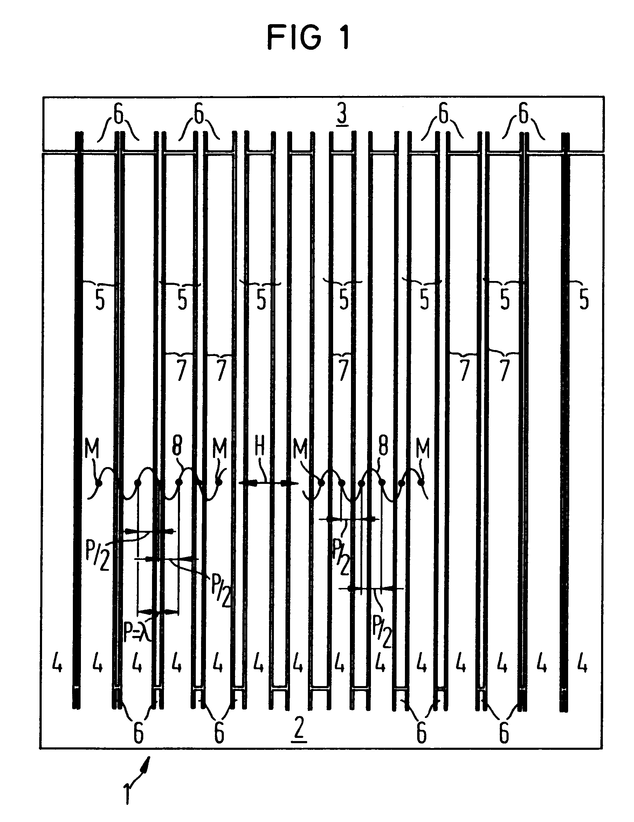

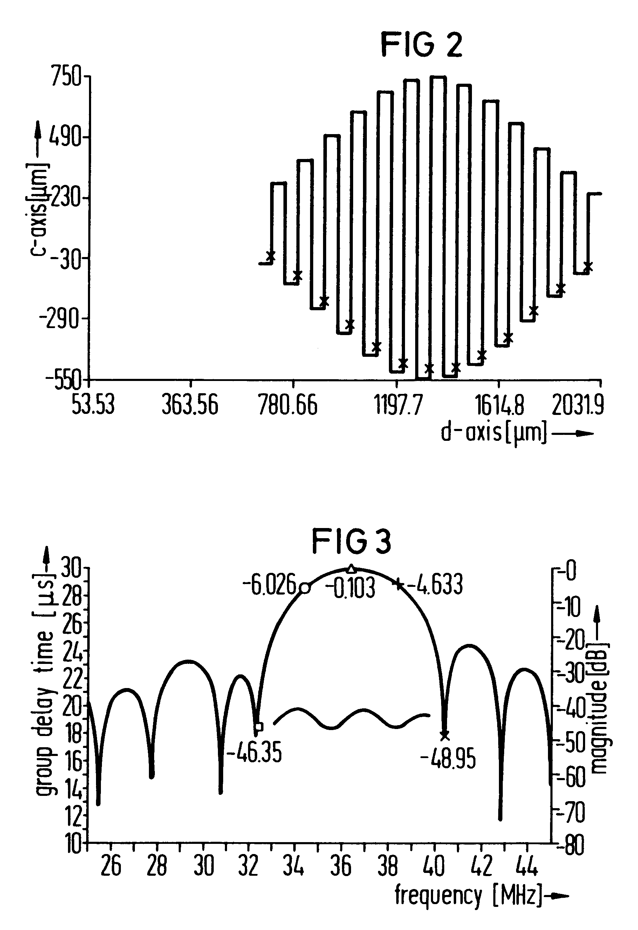

Die Figur 1 zeigt das prinzipielle Bild einer nach der Erfindung gewichteten Wandlers mit geringer Wichtung an jeweils den Enden des Wandlers. Die Übertragungskurve bzw. das Zeitsignal dieses Wandlers der Figur 1 ist bezüglich allein der Wichtung, also abgesehen von den Nebenwirkungen bei bekanntermaßen gewichteten Wandlern, äquivalent der in Figur 2 angegebenen Mäanderlinie eines fingerlängengewichteten Interdigitalwandlers.

In Figur 1 ist mit 1 der Interdigitalwandler und sind mit 2 und 3 die beiden einander gegenüberliegenden Sammelschienen bezeichnet. Mit 4 sind die mit der Sammelschiene 2 verbundenen Finger und mit 5 die mit der Sammelschiene 3 verbundenen Finger bezeichnet. Mit 6 sind die bekannten Dummy-Finger bezeichnet. Mit 7 ist auf die oben mehrfach erwähnten Zwischenräume zwischen den benachbarten Fingern 4 und 5 hingewiesen. Die mit 8 bezeichnete, in die Figur 1 eingetragene Wellenlinie ist die in Richtung der Haupt-Wellenausbreitungsrichtung H dadurch kenntlich gemachte Periodizität mit p = Lambda der akustischen Wellenlänge der Welle, die vom Wandler 1 auf bzw. in der Oberfläche des Substrats abgestrahlt wird. Ersichtlich fallen die durch große Punkte kenntlich gemachten Mitten der Breiten der Finger 4 und 5 mit im wesentlichen den "Nulldurchgängen" der Wellenlinie 8 zusammen. Dies ist für die Erfindung charakteristisch und unterscheidet sie wesentlich vom Stand der Technik.

In der schon erwähnten Figur 2 ist die Mäanderkurve 21 der Fingerlängenwichtung des Wandlers nach Figur 1 eingetragen. Das Bild der Figur 2 unterscheidet sich natürlich nicht von dem Stand der Technik, da ja die Erfindung, abgesehen von unerwünschten Nebenwirkungen, hinsichtlich der durch Wichtung erzielten Filterkurve mit dem Stand der Technik Übereinstimmendes zu liefern hat. Die Figur 3 zeigt die Übertragungsfunktion des Wandlers nach Figur 1, betrachtet gegenüber einer einzigen Überlappung des zweiten zugehörigen Wandlers des Filters. Die in Figur 3 gezeigte Übertragungsfunktion ist im wesentlichen die Fourier-Transformierte des Zeitsignals, das sich (aufgrund der bei einem Wandler nach Figur 1 im Betrieb vorliegenden Ladungsverteilung) längs der Haupt-Wellenausbreitungsrichtung H der akustischen Welle im Wandler einstellt.

Wie auch aus der Figur 1 ersichtlich, sind die Finger 4 der einen Sammelschiene 2 gleich breit oder breiter als ein Mittelmaß der Fingerbreite. In der Mitte der Wandler (wo größte Wichtung herrscht), sind die Finger 4, 5 beider Sammelschienen 2, 3 gleich breit. Dieses Mittelmaß ist gleich der halben Periodenlänge p/2, vermindert um die Breite eines Fingerzwischenraums 7. Kleine Wichtung herrscht dort, wo die Fingerbreiten sich besonders stark von diesem Mittelmaß unterscheiden (an den Wandlerenden).

Die Zuordnung von breiteren Fingern (zum Beispiel Finger 4) zur einen Sammelschiene (2) und schmaleren Fingern (zum Beispiel Finger 5) zur anderen Sammelschiene (2) kann auch innerhalb eines Wandler bereichsweise vertauscht sein (schmalere Finger an der einen Sammelschiene und dann breitere Finger an der anderen Sammelschiene).

Im "wesentlichen" periodisch positioniert ... im Anspruch 1 ist so zu verstehen, daß bei von Finger zu Finger einer Sammelschiene variierender Fingerbreite die exakte geometrische Mitte M eines Fingers etwas in die Richtung verlagert ist, in der diese Finger an Breite zunehmen.

## Patentansprüche

1. Gewichteter Interdigitalwandler für Oberflächenwellenanordnungen,
mit Sammelschienen (2, 3), mit alternierend an diese Sammelschienen (2, 3) angeschlossenen Wandlerfingern (4, 5) und mit Fingerzwischenräumen (7) zwischen den vorhandenen Wandlerfingern (4 und 5),
wobei wenigstens im Bereich der vorgegebenen Wichtung des Wandlers die Wandlerfinger (4, 5), in Hauptausbreitungsrichtung (H) der Welle (9, 9') gesehen, mit konstanter Breite der Fingerzwischenräume (7) periodisch positioniert sind,
**gekennzeichnet dadurch**,
daß der vorgegebenen Wichtung entsprechend in einem Wichtungsbereich, ausgehend von einem Mittelmaß, bei dem alle Wandlerfinger (4, 5) gleich breit sind, die Breiten der Wandlerfinger (4) der einen Sammelschiene (2) gleich oder größer und die Breiten der Wandlerfinger (5) der anderen Sammelschiene (3) gleich oder schmaler als dieses Mittelmaß sind und
daß jeweils gleichbreite Fingerzwischenräume (7) vorgesehen sind, die mit ihren Mitten gegenüber der Periodizität p der Anordnung der Wandlerfinger der vorgegebenen Wichtung entsprechend verschoben positioniert sind, und die Wandlerfinger (4, 5), bezogen auf ihre jeweilige Mitte (M), im wesentlichen periodisch positioniert sind.

2. Interdigitalwandler nach Anspruch 1, **gekennzeichnet** **dadurch**, daß die Wandlerfinger (4, 5) wenigstens in dem gewichteten Bereich konstante Fingerlängenüberlappung haben.

3. Interdigitalwandler mit Fingerwichtung nach Anspruch 1, **gekennzeichnet dadurch**, daß zusätzlich überlagerte Fingerlängen-Überlappungswichtung vorgesehen ist.

4. Oberflächenwellenfilter mit Eingangswandler und Ausgangswandler **gekennzeichnet dadurch**, daß diese beiden Wandler anteilig entsprechend der vorgegebenen Übertragungskurve gemäß Anspruch 1, 2 oder 3 gewichtet sind.

## Claims

1. Weighted interdigital transducer for surface wave arrangements, having busbars (2, 3), transducer fingers (4, 5) alternately connected to these busbars (2, 3), and finger gaps (7) between the transducer fingers (4 and 5) that are present, it being the case that, seen in the principal direction of propagation (H) of the wave (9, 9′), the transducer fingers (4, 5) are periodically positioned with a constant width of the finger gaps (7) at least in the region of the prescribed weighting of the transducer, characterized in that, starting from a mean dimension for which all transducer fingers (4, 5) are of equal width, in accordance with the prescribed weighting it is the case that in a weighting region the widths of the transducer fingers (4) of one busbar (2) are equal to or greater than, and the widths of the transducer fingers (5) of the other busbar (3) are equal to or narrower than this mean dimension, and that finger gaps (7) of equal width are provided which are positioned with their centres offset by comparison with the periodicity p of the arrangement of the transducer fingers in accordance with the prescribed weighting, and the transducer fingers (4, 5) are essentially periodically positioned with reference to their respective centre (M).

2. Interdigital transducer according to Claim 1, characterized in that the transducer fingers (4, 5) have a constant finger-length overlap at least in the weighted region.

3. Interdigital transducer with finger weighting according to Claim 1, characterized in that additionally superimposed finger-length overlap weighting is provided.

4. Surface wave filter with input transducer and output transducer, characterized in that these two transducers are weighted proportionately in accordance with the prescribed transmission curve according to Claim 1, 2 or 3.

## Revendications

1. Transducteur interdigité pondéré pour dispositifs à ondes de surface, comportant
des rails collecteurs (2,3) comportant des doigts (4,5) de transducteur, qui sont raccordés alternativement à ces rails conducteurs, et des espaces intercalaires (7) situés entre les doigts (4 et 5) du transducteur,
et dans lequel au moins dans la zone de la pondération prédéterminée du transducteur, les doigts (4,5) de ce dernier sont positionnés périodiquement en étant séparés par des espaces intercalaires (7) de largeur constante, lorsqu'on regarde dans la direction de propagation principale (H) de l'onde (9,9′),
caractérisé par le fait
que, conformément à la pondération prédéterminée, dans une gamme de pondérations, les largeurs des doigts (4) d'un rail collecteur (2) de ce transducteur sont égales ou supérieures à une cote moyenne, pour laquelle tous les doigts (4,5) du transducteur possèdent une même largeur, et les largeurs des doigts (5) de l'autre rail collecteur (3) du transducteur sont égales ou inférieures à cette valeur moyenne, et
qu'il est prévu des espaces intercalaires (7) entre les doigts, qui possèdent des largeurs respectivement égales et dont les centres sont positionnés en étant décalés de façon correspondante par rapport à la périodicité p de la disposition des doigts du transducteur, conformément à la pondération prédéterminée, et que les doigts (4,5) du transducteur sont positionnés essentiellement périodiquement par rapport à leurs centres respectifs (M).

2. Transducteur interdigité suivant la revendication 1, caractérisé par le fait que les doigts (4,5) du transducteur sont en chevauchement sur une longueur constante, au moins dans la zone pondérée.

3. Transducteur interdigité à pondération des doigts, suivant la revendication 1, caractérisé par le fait qu'il est prévu, en outre, une pondération superposée du chevauchement des longueurs de doigts.

4. Filtre d'ondes de surface comportant un transducteur d'entrée et un transducteur de sortie, caractérisé par le fait que ces deux transducteurs sont pondérés au prorata conformément à la courbe de transmission prédéterminée selon la revendication 1, 2 ou 3.
